# DEMANDE DE BREVET EUROPEEN

(11) **EP 2 390 818 A1**
(43) Date de publication de la demande: **30.11.2011**
(21) Numéro de dépôt: 10305570.3
(22) Date de dépôt: 31.05.2010
(51) Int. Cl.: G06K 7/12, G06K 19/06, G06K 7/14, G07D 7/00

(54) **Support de données avec une mémoire holographique**

(71) Demandeur: Gemalto SA, 92190 Meudon (FR)
(72) Inventeur: Allot, Francis, 92197 Meudon (FR); Bajolle, Antoine, 92197 Meudon (FR); Gaspari, Sébastien, 92197 Meudon (FR)
(74) Mandataire: Cour, Pierre

(57) **Abrégé**

Les modes de réalisation de la présente invention décrivent un support de données (7) comprenant
- une mémoire holographique (5) porté par le support et,
- un cristal photonique (1) configuré de manière, d'une part, à filtrer la lumière reçue d'une source lumineuse à large spectre afin de sélectionner une bande fréquentielle dudit spectre et d'autre part à guider la lumière correspondant à ladite bande fréquentielle sélectionnée de manière à éclairer ladite mémoire holographique selon une direction prédéterminée.

## Description

La présente invention concerne le domaine des mémoires optiques et plus particulièrement les mémoires utilisant un procédé holographique et les méthodes de lecture de ces mémoires.

En enregistrant les figures d'interférence issues de la superposition d'une lumière de référence cohérente et de cette même lumière diffractée par un objet (correspondant à l'information à enregistrer), on enregistre une image (hologramme) comprenant des informations selon les 3 dimensions puisque l'on enregistre la totalité du front d'onde de la lumière reçue (amplitude, longueur d'onde et phase). Cela permet donc l'enregistrement de nombreuses informations sur une surface réduite. L'image de l'objet (et donc les données) peut être recréée en éclairant les figures d'interférences (c'est à dire l'hologramme) par la lumière de référence. Ainsi, l'holographie permet de concevoir des mémoires avec de larges capacités.

Néanmoins, afin de recréer l'image originale à partir de l'enregistrement des figures d'interférence, la mémoire holographique doit être éclairée selon des conditions bien particulières: angle de lecture avec une faible déviation et une longueur d'onde précise afin de rester dans des conditions de lumière cohérente.

Or, la réalisation de ces conditions d'éclairement est difficile à réaliser et la lecture de la mémoire holographique dans l'état de la technique requiert un dispositif de lecture complexe et très sensible à l'environnement extérieur, ce qui rend difficile l'utilisation de telles mémoires pour le grand public.

La nécessité est donc de proposer un procédé de lecture qui permette d'accéder aux données de la mémoire holographique de manière simple et rapide.

Ainsi, la présente invention concerne un support de données comprenant
- une mémoire holographique porté par le support et,
- un cristal photonique configuré de manière, d'une part, à filtrer la lumière reçue d'une source lumineuse à large spectre afin de sélectionner une bande fréquentielle dudit spectre et d'autre part à guider la lumière correspondant à ladite bande fréquentielle sélectionnée de manière à éclairer ladite mémoire holographique selon une direction prédéterminée.

Selon un autre aspect de la présente invention, le cristal photonique comprend une bande interdite dans laquelle les longueurs d'onde comprises dans ladite bande interdite sont réfléchies de manière à créer un guide d'onde pour ces longueurs d'onde.

Selon un aspect additionnel de la présente invention, le cristal photonique comprend un résonateur optique permettant d'éclairer la mémoire holographique de manière cohérente avec le spectre lumineux correspondant à la bande fréquentielle sélectionnée.

Selon un autre mode de réalisation de la présente invention, le format dudit support correspond à une carte mémoire permettant une manipulation aisée dudit support de données.

Selon un mode de réalisation supplémentaire de la présente invention, la carte mémoire comprend une fenêtre permettant de transmettre la lumière à large spectre reçue vers le cristal photonique et dans lequel ladite fenêtre et la mémoire holographique sont positionnées sur une face commune de la carte mémoire.

Selon un mode de réalisation alternatif, la carte mémoire comprend une fenêtre permettant de transmettre la lumière à large spectre reçue vers le cristal photonique et dans lequel ladite fenêtre et la mémoire holographique sont positionnées sur des faces opposées de la carte mémoire.

La présente invention concerne également un équipement de lecture d'un support de données selon l'une des revendications précédentes comprenant:
- une source lumineuse à large spectre destinée à émettre vers le cristal photonique du support de données,
- un capteur optique destiné à détecter l'image créée par l'éclairage de la mémoire holographique,
- un module de traitement de signal destiné à traiter le signal détecté par le capteur optique afin de récupérer les données enregistrées dans la mémoire holographique.

Selon un autre aspect de la présente invention, la source lumineuse à large spectre est une source de lumière blanche.

Selon un aspect supplémentaire de la présente invention, ledit capteur optique est un capteur optique à transfert de charge (charge-coupled device (CCD) en anglais).

Selon un aspect additionnel de la présente invention, ledit capteur optique est un capteur optique semi-conducteur à oxyde de métal complémentaire (Complementary metal oxyde semiconductor (CMOS) en anglais).

La présente invention concerne également un procédé de lecture d'une mémoire holographique dans laquelle la structure d'un cristal photonique est configurée de manière, d'une part, à filtrer la lumière reçue d'une source lumineuse à large spectre afin de sélectionner une bande fréquentielle dudit spectre et d'autre part à guider la lumière correspondant à ladite bande fréquentielle sélectionnée de manière à éclairer la mémoire holographique selon une direction prédéterminée.

Selon un autre aspect de la présente invention, le cristal photonique et la mémoire holographique sont implémentés sur une carte et dans lequel la source lumineuse à large spectre et le capteur optique sont fixés dans un équipement de lecture sur lequel vient s'insérer ladite carte.

D'autres caractéristiques et avantages de l'invention apparaîtront dans la description qui va maintenant en être faite, en référence aux dessins annexés qui en représentent, à titre indicatif mais non limitatif, un mode de réalisation possible.

Sur ces dessins:
- la figure 1 représente un schéma de trois cristaux photoniques selon une (a)), deux (b)) et trois (c)) dimensions;
- la figure 2 représente un schéma d'un défaut rectiligne dans un cristal photonique correspondant à la formation d'un guide d'onde rectiligne;
- la figure 3 représente un schéma d'un défaut courbé dans un cristal photonique correspondant à la formation d'un guide d'onde courbé;

- la figure 4 représente un schéma d'un défaut annulaire dans un cristal photonique correspondant à la formation d'un résonateur optique;
- la figure 5 représente un schéma explicatif du fonctionnement des modes de réalisation de la présente invention;
- la figure 6 représente un premier mode de réalisation de la présente invention;
- la figure 7 représente un deuxième mode de réalisation de la présente invention;
- la figure 8 représente un troisième mode de réalisation de la présente invention;

Dans la description qui va suivre, on désigne de façon générale:

Le terme « source lumineuse à large spectre » définit une source lumineuse dont l'étendue spectrale comprend la longueur d'onde nécessaire pour l'éclairage d'une mémoire holographique mais également d'autre longueurs d'onde de sorte qu'un filtrage est nécessaire pour obtenir cette longueur d'onde.

Les modes réalisation de la présente invention correspondent à l'utilisation d'un cristal photonique afin de filtrer et guider le spectre issu d'une lumière blanche.

Un cristal photonique est une structure périodique de matériaux diélectriques ayant des coefficients de réfraction différents. L'arrangement périodique et la différence de coefficient de réfraction entre les deux matériaux conduit à la formation d'une « bande interdite photonique » dans laquelle les longueurs d'onde sont réfléchies. En choisissant la différence de coefficient de réfraction et en travaillant la périodicité de l'arrangement (type de réseau, diamètre des trous) ou en ajoutant des défauts ponctuels (absence, modification ou translation de motifs), il est possible d'accorder la bande interdite photonique aux besoins de l'application. Si cette bande interdite est assez fine, cela conduit à la formation d'un guide d'onde qui transmet les longueurs d'onde comprises dans la bande. Ainsi, la configuration du cristal photonique permet de sélectionner une bande spectrale que l'on veut transmettre.

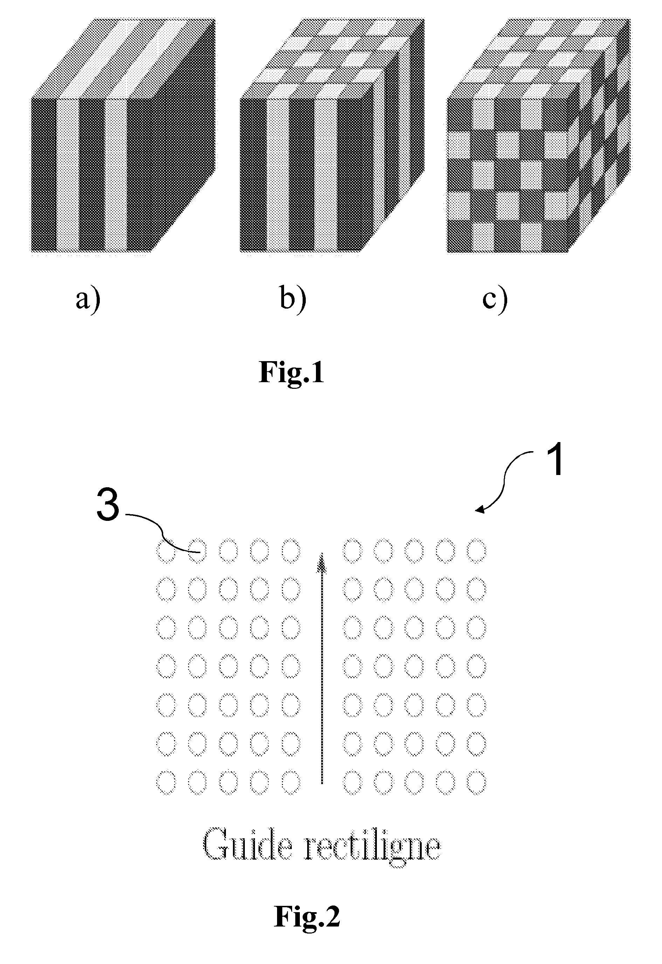

De plus, comme représenté sur la figure 1, il existe des cristaux photoniques à une dimension (a)), deux dimensions (b)) ou trois dimensions (c)). Dans le cas d'un cristal bidimensionnel, il est généralement constitué d'un réseau de trous percés dans un matériau diélectrique ou de colonnes de diélectriques dans l'air. Dans les deux cas, l'introduction d'un défaut localisé (absence de trou ou de colonne) entraîne le confinement du mode électromagnétique dont l'énergie est comprise dans la bande interdite du cristal photonique situé autour. Cela correspond à la création d'une cavité à la longueur d'onde correspondante , cette longueur d'onde variant en fonction de la taille (rayon) du défaut. Ce confinement permet de créer une source lumineuse intense et de faible étendue spectrale.

De la même manière, en créant des défauts étendus invariants par translation (c'est-à-dire très grand devant la longueur d'onde) dans au moins une dimension, on peut orienter la propagation de la lumière et créer des guides d'onde dans une direction choisie comme représenté sur la figure 2.

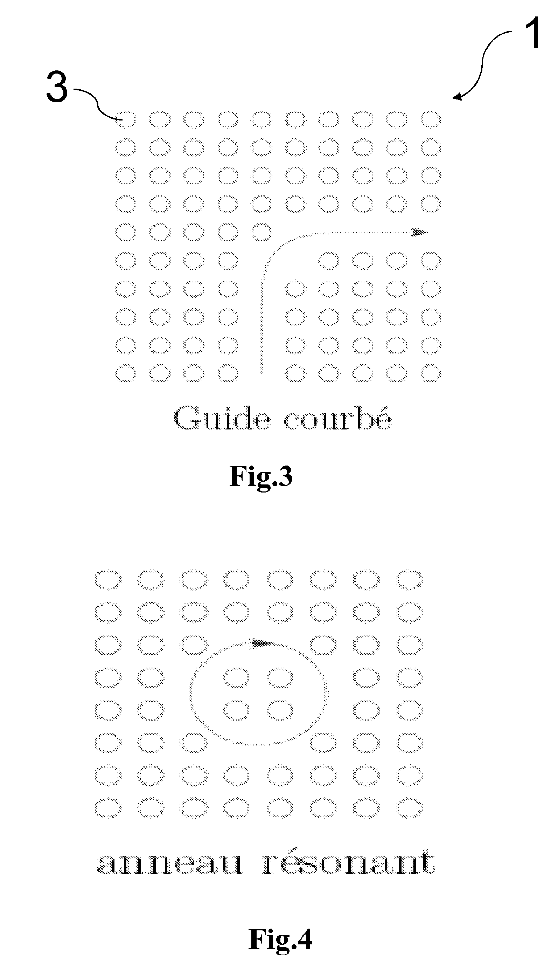

On peut également obtenir des guides d'onde courbés comme représenté sur la figure 3. Enfin, une configuration en résonateur optique (fig.4) permet d'émettre le spectre transmis par le cristal photonique sous forme de lumière cohérente. Une telle « fonction optique » correspond à la réalisation de lasers à cristaux photoniques à mode de défauts (cavité optique formée par un défaut ponctuel dans un cristal photonique) ou à mode « bord de bande ».

Il est à noter que la fabrication des cristaux photoniques tels que décrits précédemment afin de permettre des fonctions de filtrage, de guidage et d'émission d'une lumière reçue est connue dans l'état de la technique (Joannopoulos (J. D.), Meade (R. D.) et Winn (J. N.), « Photonic Crystals : Molding the Flow of Light ». Princeton University Press, 1995; Romuald Houdré, « Cours de l'école doctorale de photonique, EDPO PO-014 2009 », EPFL,2009 ; Josselin Mouette, « Micro-résonateurs sans cavités à base de cristaux photoniques bidimensionnels », rapport stage DEA, 2001).

D'autre part, il est à noter que la présente invention concerne la lecture des mémoires holographiques mais pas l'écriture qui demande également des conditions bien spécifiques (lumière cohérente...).

Selon un mode de réalisation, le cristal photonique 1 et la mémoire holographique 5 sont situés sur une carte commune 7 de manière à faciliter la manipulation de la mémoire holographique 5 et à fixer le cristal holographique 1 dans la configuration et la position voulue par rapport à la mémoire holographique 5.

La carte 7 comprend également une fenêtre transparente 9 afin de recevoir une lumière à large spectre 11 émise par un dispositif de lecture 13. Cette lumière à large spectre 11 transmise à travers la fenêtre transparente 9 est alors reçue par une première partie 15 du cristal photonique 1 dont la configuration permet le filtrage de la lumière à large spectre 11 reçue de manière à sélectionner la bande spectrale désirée pour éclairer la mémoire holographique 5. La bande spectrale filtrée est alors transmise vers la mémoire holographique 5 par une deuxième partie 17 du cristal photonique 1 comprenant une configuration en guide d'onde tel que décrit précédemment. En pratique le cristal photonique est constitué d'un unique bloc avec différents arrangements de trous pour obtenir le signal lumineux désiré pour éclairer la mémoire holographique, de plus les fonctions de filtrage et de guidage correspondent à un unique arrangement en guide d'onde puisque comme décrit précédemment seules les longueurs d'onde de la bande interdite sont transmise par le guide d'onde.

Enfin, la bande spectrale sélectionnée est reçue par une troisième partie 19 du cristal photonique 1 dont la configuration en résonateur optique permet la radiation du spectre sélectionné vers la mémoire holographique 5 selon l'angle désiré. Ainsi, le cristal photonique est configuré de telle manière que l'angle d'incidence et la largeur spectrale obtenus correspondent à la lumière de référence utilisée lors de l'écriture de la mémoire holographique.

L'image formée par l'éclairage de la mémoire holographique 5 est alors analysée par un détecteur optique 21 situé sur le dispositif de lecture 13.

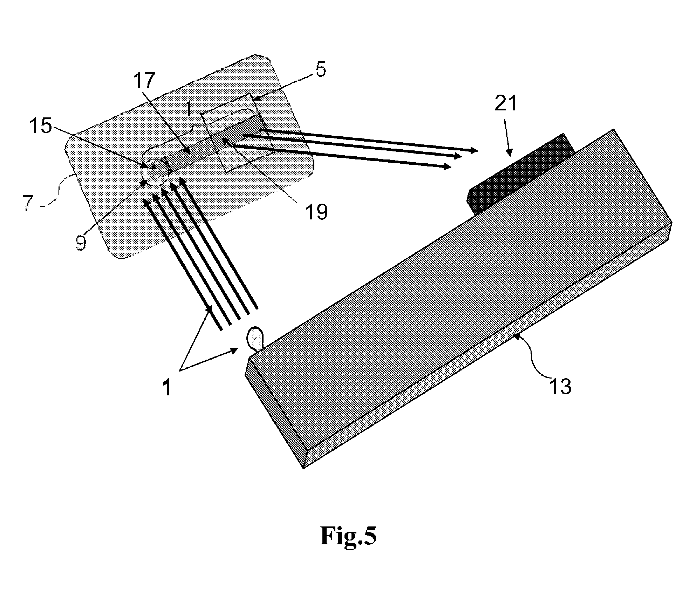

La figure 5 est un schéma explicatif afin de préciser le fonctionnement de l'invention.

En pratique, selon les modes de réalisation de la présente invention, la carte 7 vient se fixer sur le dispositif de lecture 13 afin que son positionnement permette l'éclairage de la fenêtre transparente 9 par la source de lumière à large spectre 11 puis la formation de l'image de la mémoire holographique 5 au niveau du capteur optique 21.

La source lumineuse à large spectre 11 peut être, par exemple, une lampe à incandescence ou une diode électroluminescente de sorte que son étendue spectrale peut être plus ou moins grande, l'important étant que le spectre de cette source lumineuse comprenne la longueur d'onde nécessaire à l'éclairement de la mémoire holographique 5.

Le capteur optique 21 peut être un capteur optique à transfert de charge (charge-coupled device (CCD) en anglais) ou un capteur optique semi-conducteur à oxyde de métal complémentaire (Complementary metal oxyde semiconductor (CMOS) en anglais). Par ailleurs, le signal issu du capteur optique est analysé par un module électronique de traitement de signal afin de convertir les informations contenues dans la mémoire holographique au format désiré.

Différentes configurations sont possibles pour aboutir à la lecture d'une mémoire holographique selon le fonctionnement décrit précédemment.

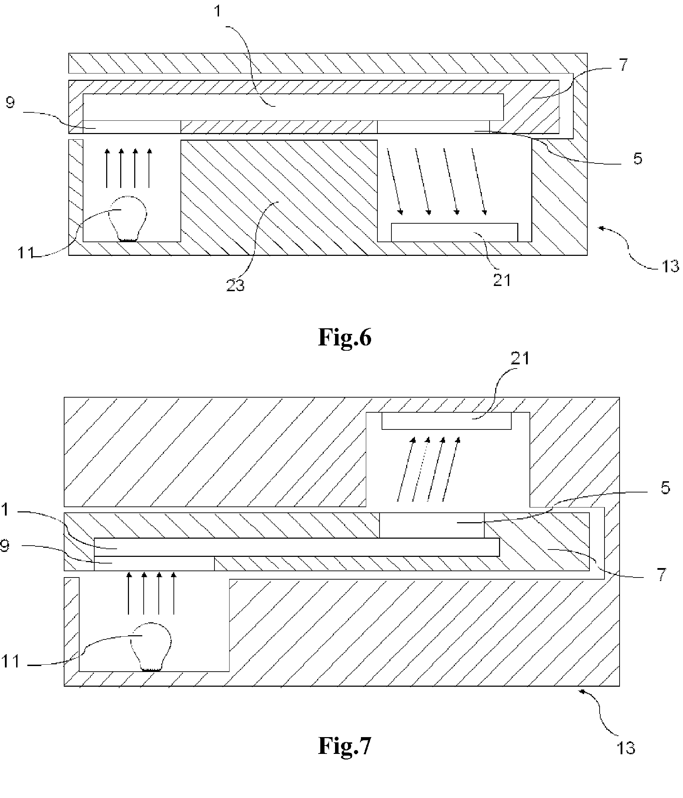

Selon un premier mode de réalisation présenté sur la figure 6, la carte une fois insérée dans le lecteur est éclairée par une source lumineuse à large spectre 11 au niveau de sa fenêtre 9. La lumière est alors filtrée et guidée par le cristal photonique 1 puis diffusée par ce même cristal 1 vers la mémoire holographique 5. Les rayons lumineux sont alors diffractés vers le capteur 21 situé du même côté de la carte mémoire 7 que la lumière à large spectre. Dans cette configuration, la protubérance 23 du lecteur 13 permet d'une part de maintenir la carte 7 en position et d'autre part d'éviter le rayonnement de la lumière à large spectre 11 vers le capteur 21 ce qui pourrait perturber la lecture de la mémoire holographique 5. Les flèches représentent la transmission de lumière dans l'air, c'est-à-dire, entre la source lumineuse large spectre 11 et la fenêtre 9 de la carte mémoire 7 d'une part et entre la mémoire holographique 5 et la capteur optique 21 d'autre part.

Selon un deuxième mode de réalisation présenté sur la figure 7, la source lumineuse à large spectre 11 et le capteur optique 21 se trouve de part et d'autre de la carte mémoire lorsque cette dernière est insérée dans le lecteur. Une telle configuration permet d'éviter toute perturbation de lecture du capteur 21 due à la source lumineuse 11.

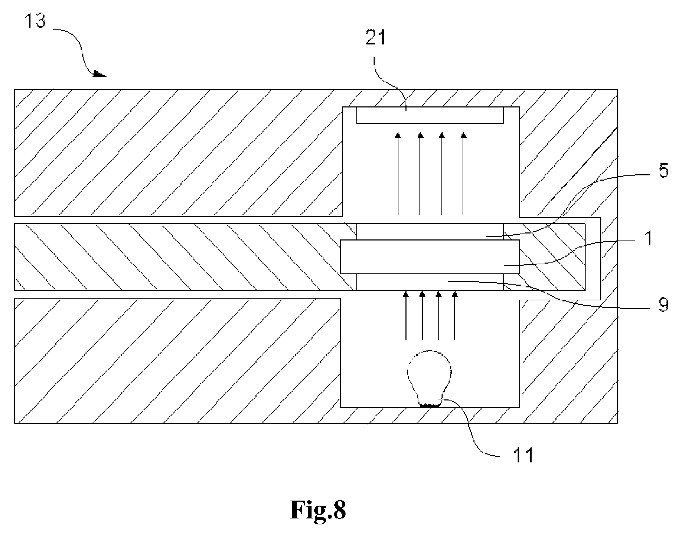

Enfin, selon un troisième mode de réalisation présenté sur la figure 8, la fenêtre 9, le cristal photonique 1 et la mémoire holographique 5 sont concentrés sur l'épaisseur de la carte de sorte que la source lumineuse 11 et la capteur optique 21 sont disposés de manière symétrique des deux cotés de la carte, ce qui permet de réduire la taille de la carte mémoire 7.

Ainsi, la présente invention permet, grâce à l'utilisation des propriétés des cristaux photoniques de concevoir un procédé de lecture des mémoires holographiques rapide et dont le coût est limité du fait de l'absence de source lumineuse cohérente. De plus l'implémentation sur une carte permet de faciliter la manipulation de la mémoire holographique et l'utilisation de cristaux photoniques de simplifier sa lecture. Par ailleurs, l'utilisation d'une mémoire holographique implantée sur une carte permet une grande robustesse puisque même en cas de bris de la mémoire holographique, l'ensemble des données peut être récupéré avec seulement une fraction de la mémoire holographique.

## Revendications

1. Support de données comprenant
- une mémoire holographique (5) porté par le support et,
- un cristal photonique (1) configuré de manière, d'une part, à filtrer la lumière reçue d'une source lumineuse à large spectre (11) afin de sélectionner une bande fréquentielle dudit spectre et d'autre part à guider la lumière correspondant à ladite bande fréquentielle sélectionnée de manière à éclairer ladite mémoire holographique (5) selon une direction prédéterminée.

2. Support de données selon la revendication 1 dans lequel le cristal photonique (1) comprend une bande interdite dans laquelle les longueurs d'onde comprises dans ladite bande interdite sont réfléchies de manière à créer un guide d'onde pour ces longueurs d'onde.

3. Support de données selon la revendication 1 ou 2 dans lequel le cristal photonique (1) comprend un résonateur optique permettant d'éclairer la mémoire holographique (5) de manière cohérente avec le spectre lumineux correspondant à la bande fréquentielle sélectionnée.

4. Support de données selon l'une des revendications précédentes dans lequel le format dudit support correspond à une carte mémoire (7) permettant une manipulation aisée dudit support de données.

5. Support de données selon la revendication 4 dans lequel la carte mémoire (7) comprend une fenêtre (9) permettant de transmettre la lumière à large spectre reçue vers le cristal photonique (1) et dans lequel ladite fenêtre (9) et la mémoire holographique (5) sont positionnées sur une face commune de la carte mémoire (7).

6. Support de données selon la revendication 4 dans lequel la carte mémoire (7) comprend une fenêtre (9) permettant de transmettre la lumière à large spectre reçue vers le cristal photonique (1) et dans lequel ladite fenêtre (9) et la mémoire holographique (5) sont positionnées sur des faces opposées de la carte mémoire (7).

7. Equipement de lecture (13) d'un support de données selon l'une des revendications précédentes comprenant:
- une source lumineuse à large spectre (11) destinée à émettre vers le cristal photonique (1) du support de données,
- un capteur optique (21) destiné à détecter l'image créée par l'éclairage de la mémoire holographique (5),
- un module de traitement de signal destiné à traiter le signal détecté par le capteur optique (21) afin de récupérer les données enregistrées dans la mémoire holographique (5).

8. Equipement de lecture selon la revendication 5 dans lequel la source lumineuse à large spectre (11) est une source de lumière blanche.

9. Equipement de lecture selon la revendication 5 ou 6 dans lequel ledit capteur optique (21) est un capteur optique à transfert de charge (charge-coupled device (CCD) en anglais).

10. Equipement de lecture selon la revendication 5 ou 6 dans lequel ledit capteur optique (21) est un capteur optique semi-conducteur à oxyde de métal complémentaire (Complementary metal oxyde semiconductor (CMOS) en anglais).

11. Procédé de lecture d'une mémoire holographique (5) dans laquelle la structure d'un cristal photonique (1) est configurée de manière, d'une part, à filtrer la lumière reçue d'une source lumineuse à large spectre (11) afin de sélectionner une bande fréquentielle dudit spectre et d'autre part à guider la lumière correspondant à ladite bande fréquentielle sélectionnée de manière à éclairer la mémoire holographique (5) selon une direction prédéterminée.

12. Procédé selon la revendication 9 dans lequel le cristal photonique (1) et la mémoire holographique (5) sont implémentés sur une carte (7) et dans lequel la source lumineuse à large spectre (11) et le capteur optique (21) sont fixés dans un équipement de lecture (13) sur lequel vient s'insérer ladite carte (7).
